# EUROPÄISCHE PATENTANMELDUNG

(11) **EP 1 391 934 A2**
(43) Veröffentlichungstag der Anmeldung: **25.02.2004**
(21) Anmeldenummer: 03018593.8
(22) Anmeldetag: 19.08.2003
(51) Int. Cl.: H01L 27/148, H01L 31/0203

(54) **Sensormodul**

(30) Priorität: 23.08.2002 DE 10239524
(71) Anmelder: Z/I Imaging GmbH, 73447 Oberkochen (DE)
(72) Erfinder: Trunz, Michael, 73479 Ellwangen-Pfuhlheim (DE); Hinz, Alexander, Dr., 89551 Koenigsbronn (DE)
(74) Vertreter: Lorenz, Werner, Dr.-Ing.

(57) **Zusammenfassung**

Ein Sensormodul hat eine in einem Gehäuse 2 angeordnete CCD-Sensoreinheit 4. Zwischen einer Gehäusefläche 8 und der CCD-Sensoreinheit ist eine plattenförmige Trägereinheit 6 vorgesehen, welche die CCD-Sensoreinheit 4 trägt.

## Beschreibung

Die Erfindung betrifft ein Sensormodul mit einer CCD-Sensoreinheit, die in einem Gehäuse angeordnet ist.

Ein derartiges Sensormodul ist aus der DE 100 57 647 A1 bekannt. Dort ist ein Sensormodul mit einer als CCD-Chip ausgebildeten CCD-Sensoreinheit beschrieben, welche in einem Gehäuse angeordnet ist. Das Gehäuse ist auf einer zum lichtempfindlichen Bereich der CCD-Sensoreinheit weisenden Seite mit einer Glasplatte abgeschlossen. Die CCD-Sensoreinheit ist direkt auf einer Gehäusefläche am Boden des Gehäuses angeordnet.

Die Firma Philips vertreibt unter der Bezeichnung FTF 3020-M einen Full Frame CCD Image Sensor ein Sensormodul, das einen CCD-Chip aus einkristallinem Silizium umfasst. Dieser CCD-Chip ist auf dem Boden eines Keramikgehäuses aufgeklebt. Das Keramikgehäuse ist mit einem Abschlussglas optischer Qualität hermetisch verschlossen. An dem Keramikgehäuse sind elektrische Anschlusskontakte ausgebildet. Diese Anschlusskontakte sind mit entsprechendem Kontaktbereichen auf dem CCD-Chip, über dünne Golddrähte verbunden.

Aufgabe der Erfindung ist es, einen elektrooptischen Sensor für eine metrische Kamera bereitzustellen, der auch unter den Betriebsbedingungen einer Luftbildkamera über einen Temperaturbereich von -40°C bis +70°C und einem Druckbereich von ca. 1000 mbar bis 300 mbar Bildfehler von weniger als 1 µm gewährleistet.

Diese Aufgabe wird durch ein Sensormodul mit den Merkmalen des Anspruchs 1 gelöst.

Ein solches Sensormodul hat eine CCD-Sensoreinheit, die in einem Gehäuse angeordnet ist, wobei zwischen einer Gehäusefläche und der CCD-Sensoreinheit eine plattenförmige Trägereinheit vorgesehen ist, welche die CCD-Sensoreinheit trägt. Auf diese Weise wird gewährleistet, dass sich mechanische Spannungen des Gehäuses nicht auf die CCD-Sensoreinheit übertragen, so dass Temperatur- und Druckschwankungen keine Geometrieänderungen der lichtempfindlichen Fläche der CCD-Sensoreinheit hervorrufen und es hierdurch auch zu keiner Positionsänderung von CCD-Pixeln kommt.

In Weiterbildung der Erfindung entspricht die thermische Ausdehnung der plattenförmigen Trägereinheit der thermischen Ausdehnung der CCD-Sensoreinheit. Auf diese Weise wird ein Sensormodul geschaffen, bei dem über einen weiten Temperaturbereich keine Bildfehler auftreten.

In Weiterbildung der Erfindung besteht die plattenförmige Trägereinheit aus Aluminiumnitrit (AlN) Auf diese Weise wird eine mechanisch stabile Trägereinheit geschaffen, bei der eine Temperaturausdehnung an diejenige des CCD-Chips angepasst ist.

In Weiterbildung der Erfindung ist die plattenförmige Trägereinheit mit einem quasi punktförmigen Verbindungsbereich an einer Gehäusefläche festgelegt. Unter einem quasi punktförmigen Verbindungsbereich wird dabei ein Verbindungsbereich verstanden, dessen Fläche wesentlich kleiner ist als die der plattenförmigen Trägereinheit. Auf diese Weise wird eine mechanische Entkopplung von Gehäuse und Trägereinheit bewirkt, so dass eine Ausdehnung oder eine Kontraktion des Gehäuses keine mechanische Spannungen in der Trägereinheit hervorruft.

In Weiterbildung der Erfindung ist die Trägereinheit an dem Gehäuse mit einer Klebeverbindung oder Lötverbindung festgelegt. Auf diese Weise entsteht zwischen Gehäuse und Trägereinheit ein kleiner Abstand und es wird gleichzeitig zwischen diesen Einheiten eine mechanische Verbindung geschaffen, die einen guten Wärmefluß zwischen Trägereinheit und Gehäuse ermöglicht und sich darüber hinaus auch gut zur Herstellung in einem Massenproduktionsprozess eignet.

In Weiterbildung der Erfindung ist die CCD-Sensoreinheit an der Trägereinheit mit einer Klebeverbindung festgelegt. Auf diese Weise kann die CCD-Sensoreinheit an der Trägereinheit ohne Auftreten mechanischer Spannungen festgehalten werden.

In Weiterbildung der Erfindung weist das Gehäuse eine Glasplatte auf. Auf diese Weise kann die CCD-Sensoreinheit vor schädlichen Umwelteinflüssen geschützt werden.

In Weiterbildung der Erfindung schließt die Glasplatte das Gehäuse hermetisch ab. Auf diese Weise können Alterungserscheinungen der CCD-Sensoreinheit, etwa eine Oxidation von deren Oberfläche, weitestgehend unterbunden werden.

In Weiterbildung der Erfindung weichen die Ausdehnungskoeffizienten von Glasplatte und Gehäuse um weniger als 5 x 10⁻⁶ ° K⁻¹ voneinander ab. Auf diese Weise können am Gehäuse auf Grund von Temperaturschwankungen auftretende mechanische Spannungen reduziert werden,

In Weiterbildung der Erfindung ist das Gehäuse als PGA (Pin Grid Array) - Gehäuse ausgebildet. Auf diese Weise wird ein leicht austauschbares Sensormodul geschaffen.

In Weiterbildung der Erfindung besteht das Gehäuse aus Al₂O₃. Auf diese Weise wird ein robustes Gehäuse bereitgestellt.

Eine Kamera mit einem erfindungsgemäßen Sensormodul ermöglicht hochgenaue Luftbildaufnahmen auch mit kleinen Flugzeugen, ohne Druckkabine und Einrichtung zur thermischen Stabilisierung der Kamera.

Eine vorteilhafte Ausführungsform der Erfindung ist in den Zeichnungen dargestellt und wird nachfolgend beschrieben.

Es zeigen:
- Figur 1:: eine perspektivische Ansicht des Sensormoduls; und
- Figur 2:: eine Schnittansicht des Sensormoduls entlang der Linie II- II aus Fig. 1.

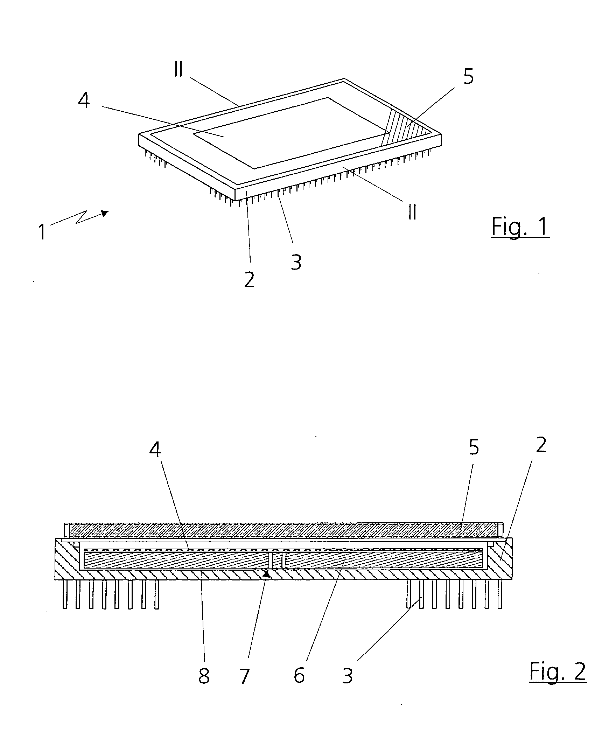

Das Sensormodul 1 aus Fig. 1 besteht aus einem PGA (Pin Grid Array)-Gehäuse 2, das aus Al₂O₃ aufgebaut ist. An dem Gehäuse sind Kontaktfüße 3 ausgebildet, so dass sich das Sensormodul zum Einsatz in einer Kamera, etwa einer Luftbildkamera eignet und dort leicht ausgetauscht werden kann. Die Kontaktfüße 3 sind über nicht weiter dargestellte Bonddrähte mit Anschlüssen an der CCD-Sensoreinheit 4 verbunden. Die CCD-Sensoreinheit 4 ist als ein kristalliner Silizium-Chip gehalten, dessen lichtempfindliche Fläche eine Ausdehnung von etwa 40 cm² hat. In dem Gehäuse 2 wird die CCD-Sensoreinheit 4 mittels einer Glasplatte 5 von optischer Güte hermetisch abgeschlossen.

Die Fig.2 zeigt einen Schnitt des Sensormoduls entlang der Linie II-II aus Fig. 1. Dabei sind in der Fig.2 Baugruppen, die den aus Fig.1 entsprechen, mit gleichen Bezugszeichen wie in Fig. 1 versehen.

Die CCD-Sensoreinheit 4 ist auf eine plattenförmige Trägereinheit 6 aufgeklebt, welche aus Aluminiumnitrit (AlN) besteht. Damit ist thermische Ausdehnung der Trägereinheit 6 an diejenige der CCD-Sensoreinheit 4 angepasst. Die lateralen Ausdehnungen von CCD-Sensoreinheit 4 und der Trägereinheit 6 entsprechen dabei einander. In dem Gehäuse 2 sind jedoch Spielräume zwischen der Glasplatte 5 und der CCD-Sensoreinheit 4 sowie zwischen der Wandung des Gehäuses 2 und der Trägereinheit 6 mit der CCD-Sensoreinheit 4 vorgesehen.

Die Trägereinheit 6 selbst mit der CCD-Sensoreinheit 4 ist mittig an einer Bodenfläche 8 des Gehäuses 2 mittels einer Klebeverbindung 7 festgelegt, deren Durchmesser mit etwa 30 bis 35 mm deutlich geringer ist als die Abmessungen von der Trägereinheit 6 und der Bodenfläche 8 des Gehäuses. Diese Form der Verbindung wird daher als quasi punktförmig bezeichnet. Es sei bemerkt, dass zur Verbindung von Trägereinheit 6 und der Bodenfläche 8 des Gehäuses anstatt einer Klebeverbindung 7 grundsätzlich auch eine Lötverbindung vorgesehen werden kann.

Die quasi punktförmige Klebeverbindung 7 zwischen Trägereinheit 6 und der Bodenfläche 8 gewährleistet einen schmalen Abstandsspalt zwischen Trägereinheit 6 und Bodenfläche 8. Dies bewirkt, dass auch im Falle von Temperaturschwankungen und bei hohen sich ändernden Außendrücken eine thermische Ausdehnung bzw. Bewegung der Wandungen des Gehäuses 2 mit der Glasplatte 5 die Trägereinheit 6 mit der CCD-Sensoreinheit 4 stabil festgehalten wird. Zusätzlich ermöglicht die mechanische Verbindung von Trägereinheit 6 und Bodenfläche 8 einen guten Wärmefluß zwischen Trägereinheit 6 und Gehäuse 2.

Diese Montageform für die CCD-Sensoreinheit 4 gewährleistet weiter, dass die lichtempfindliche Fläche der CCD-Sensoreinheit 4 auch bei sich ändernden Umwelteinflüssen keinen mechanischen Spannungen ausgesetzt ist und stets eben verläuft.

Um die thermische Belastbarkeit des Gehäuses 2 zu maximieren, sind die Glasplatte 5 und das Material der Wandungen des Gehäuses 2 so aufeinander abgestimmt, dass deren thermische Ausdehnungskoeffizienten um weniger als 5 x 10⁻⁶ K⁻¹ voneinander abweichen. Um die CCD-Sensoreinheit 4 vor Verschmutzungen und Korrosion zu schützen, ist das Gehäuse 2 von der Glasplatte 5 hermetisch abgeschlossen. Vorzugsweise wird vor dem hermetischen Verschließen des Gehäuses dieses mit trockenem Stickstoff befüllt. Aufgrund dieses hermetischen Abschlusses führen jedoch Schwankungen des Außendruckes bei dem Sensormodul 1 dazu, dass dieses als Druckdose arbeitet, deren Geometrie luftdruckabhängig deformiert wird. Dabei kommt es zu entsprechenden Verbiegungen von Wandung und Glasplatte. Die punktförmige Klebeverbindung 7 zwischen der Bodenfläche 8 des Gehäuses 2 und der Trägereinheit 6 aus Aluminiumnitrit bewirkt jedoch, dass sich metrische Änderungen des Körpers des Gehäuses 6 nicht auf die Geometrie der lichtempfindlichen Fläche der CCD-Sensoreinheit übertragen.

## Patentansprüche

1. Sensormodul
mit einer CCD-Sensoreinheit,
die in einem Gehäuse angeordnet ist,
**dadurch gekennzeichnet, dass**
zwischen einer Gehäusefläche (8) und der CCD-Sensoreinheit (4) eine plattenförmige Trägereinheit (6) vorgesehen ist, welche die CCD-Sensoreinheit (4) trägt.

2. Sensormodul nach Anspruch 1, **dadurch gekennzeichnet, dass** die thermische Ausdehnung der plattenförmigen Trägereinheit (6) der thermischen Ausdehnung der CCD-Sensoreinheit (4) entspricht.

3. Sensoreinheit nach Anspruch 1 oder 2, **dadurch gekennzeichnet, dass** die plattenförmige Trägereinheit (6) aus Aluminiumnitrit (AIN) besteht.

4. Sensoreinheit nach Anspruch 3, **dadurch gekennzeichnet, dass** die plattenförmige Trägereinheit (6) mit einem quasi punktförmigen Verbindungsbereich (7) an einer Gehäusefläche (8) festgelegt ist.

5. Sensoreinheit nach einem der Ansprüche 1 bis 4, **dadurch gekennzeichnet, dass** die Trägereinheit (6) an dem Gehäuse (2) mit einer Klebeverbindung (7) oder Lötverbindung festgelegt ist.

6. Sensoreinheit nach einem der Ansprüche 1 bis 5, **dadurch gekennzeichnet, dass** zwischen Trägereinheit (6) und Gehäuse (2) ein Abstandsspalt ausgebildet ist.

7. Sensoreinheit nach einem der Ansprüche 1 bis 6, **dadurch gekennzeichnet, dass** die CCD-Sensoreinheit (4) an der Trägereinheit (6) mit einer Klebeverbindung oder Lötverbindung festgelegt ist.

8. Sensoreinheit nach einem der Ansprüche 1 bis 7, **dadurch gekennzeichnet, dass** das Gehäuse (2) eine Glasplatte (5) aufweist.

9. Sensoreinheit nach Anspruch 8, **dadurch gekennzeichnet, dass** die Glasplatte (5) das Gehäuse (2) hermetisch abschließt.

10. Sensoreinheit nach Anspruch 8 oder Anspruch 9, **dadurch gekennzeichnet, dass** die thermischen Ausdehnungskoeffizienten von Glasplatte (5) und Gehäuse (2) um weniger als 5 x 10⁻⁶ ° K⁻¹ voneinander abweichen.

11. Sensoreinheit nach einem der Ansprüche 1 bis 10, **dadurch gekennzeichnet, dass** das Gehäuse als PGA-Gehäuse (2) ausgebildet ist.

12. Sensoreinheit nach einem der Ansprüche 1 bis 11, **dadurch gekennzeichnet, dass** das Gehäuse (2) aus Al₂O₃ besteht.

13. Kamera mit einem Sensormodul gemäß einem der Ansprüche 1 bis 12.
